# EUROPEAN PATENT APPLICATION

(11) **EP 1 724 822 A1**
(43) Date of publication of application: **22.11.2006**
(21) Application number: 06009879.5
(22) Date of filing: 12.05.2006
(51) Int. Cl.: H01L 21/329, H01L 29/861

(54) **Semiconductor substrate and manufacturing method thereof**

(30) Priority: 17.05.2005 JP 2005143497
(71) Applicant: SUMCO Corporation, Minato-ku Tokyo (JP); DENSO CORPORATION, Kariya-shi, Aichi-ken (JP)
(72) Inventor: Nogami, Syouji, Minato-ku Tokyo (JP); Yamaoka, Tomonori, Minato-ku Tokyo (JP); Yamauchi, Shoichi, Kariya-shi, Aichi (JP); Yamaguchi, Hitoshi, Kariya-shi, Aichi (JP)
(74) Representative: Albrecht, Thomas

(57) **Abstract**

In order to suppress deterioration in charge balance and maintain excellent withstand voltage characteristics after forming a super junction structure on a semiconductor substrate, a plurality of columnar first epitaxial layers are respectively formed on a surface of a substrate main body at predetermined intervals, and a plurality of second epitaxial layers are respectively formed in trenches between the plurality of first epitaxial layers. A concentration distribution of a dopant included in the first epitaxial layer in a surface parallel with the surface of the substrate main body is configured to match with a concentration distribution of a dopant included in the second epitaxial layer in a surface parallel with the surface of the substrate main body.

## Description

### BACKGROUND OF THE INVENTION

### 1. Field of the Invention

The present invention relates to a semiconductor substrate having an epitaxial layer formed in a trench, and a manufacturing method of a semiconductor substrate for forming an epitaxial layer in a trench by using an epitaxial growth method.

### 2. Description of the Related Art

As a manufacturing method of this type of semiconductor substrate, there has been conventionally disclosed a manufacturing method of a semiconductor substrate (see, e.g., Patent Reference 1) by which an epitaxial film is formed on a semiconductor substrate including the inside of a trench based on an epitaxial growth method, etching processing with respect to a part of this epitaxial film and film formation processing with respect to the epitaxial film are repeated more than once, and the inside of the trench is filled with the superimposed epitaxial films.

In the semiconductor substrate manufactured by such a method, since an opening portion of the trench is increased by performing etching processing with respect to a part of the epitaxial film, executing film formation of the epitaxial film in this state can prevent the opening portion of the trench from being closed. As a result, generation of an embedding defect (voids) in the trench can be suppressed.

[Patent Reference 1] Japanese Patent Application Laid-open No. 2001-196573 (claim 4, paragraphs [0015] and [0016])

However, in the manufacturing method of a semiconductor substrate disclosed in Patent Reference 1 according to the prior art, although an embedding defect (voids) can be suppressed from being generated in the trench, since a dopant concentration distribution of a columnar part of a semiconductor substrate upper portion and a dopant concentration distribution of the epitaxial film in the trench are discontinuous, charge balance is deteriorated after forming a super junction structure, and electrical characteristics of the semiconductor substrate, especially withstand voltage characteristics are disadvantageously lowered. Here, the super junction structure means a structure in which an N-type region and a P-type region are alternately aligned in a direction vertical to a current direction in a drift region, and the charge balance means a carrier amount of each of an N-type semiconductor layer and a P-type semiconductor layer which is required to generate a depletion layer from a PN junction of the N-type region and the P-type region constituting the drift region to assure a high withstand voltage at the time of off.

Furthermore, as a film formation gas of the epitaxial film, when a chlorine mixed gas such as dichlorsilane (SiH₂Cl₂) or trichlorsilane (SiHCl₃) is used or a mixed gas in which an HCl gas is mixed, i.e., a halide is mixed in an Si source gas is used in place of monosilane (SiH₄), a supply amount of the mixed gas can be further precisely controlled. Therefore, voids in the epitaxial film can be reduced. However, forming the epitaxial film by using the mixed gas increases a change in dopant concentration distribution in this epitaxial film. In particular, when HCl is used as a halide, a reaction distance by Cl is decreased. Therefore, there has been a problem that discontinuity of the dopant concentration distribution of the columnar part of the semiconductor substrate upper portion and the dopant concentration distribution of the epitaxial film in the trench becomes prominent.

### SUMMARY OF THE INVENTION

It is an object of the present invention to provide a semiconductor substrate and a manufacturing method thereof which can suppress deterioration in charge balance and maintain excellent withstand voltage characteristics after forming a super junction structure.

It is another object of the present invention to provide a semiconductor substrate and a manufacturing method thereof which can reduce voids in a second epitaxial layer and match a dopant concentration distribution in a surface parallel to or vertical to a substrate main body surface in the second epitaxial layer.

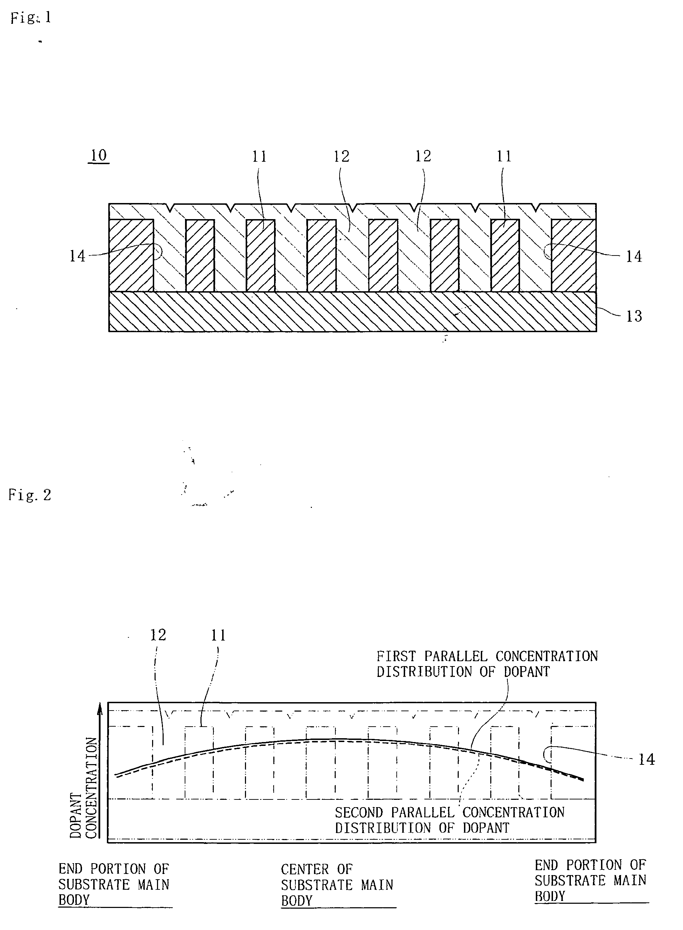

According to the invention defined in claim 1, as shown in FIGS. 1 and 2, there is provided an improvement in a semiconductor substrate having a structure in which a plurality of columnar first epitaxial layers 11 are respectively formed on a surface of a substrate main body 13 at predetermined intervals and a plurality of second epitaxial layers 12 are respectively formed in trenches 14 between the plurality of first epitaxial layers 11.

Its characteristic structure lies in that a concentration distribution of a dopant included in each first epitaxial layer 11 in a surface parallel with the surface of the substrate main body 13 is configured to match with a concentration distribution of a dopant included in each second epitaxial layer 12 in a surface parallel with the surface of the substrate main body 13.

In this semiconductor substrate defined in claim 1, since the concentration distribution of the dopant included in each first epitaxial layer 11 in a surface parallel with the surface of the substrate main body 13 has the same tendency as the concentration distribution of the dopant included in each second epitaxial layer 12 in a surface parallel with the surface of the substrate main body 13, a carrier amount contained in the first epitaxial layer 11 becomes substantially equal to a carrier amount contained in the second epitaxial layer 12 adjacent to the first epitaxial layer 11. As a result, a carrier amount in an N-type region becomes substantially equal to a carrier amount in a P-type region adjacent to the N-type region after forming the super junction structure on a semiconductor substrate 10, and hence a depletion layer is generated from a PN junction of the N-type region and the P-type region at the time of off, thereby completely depleting a drift region.

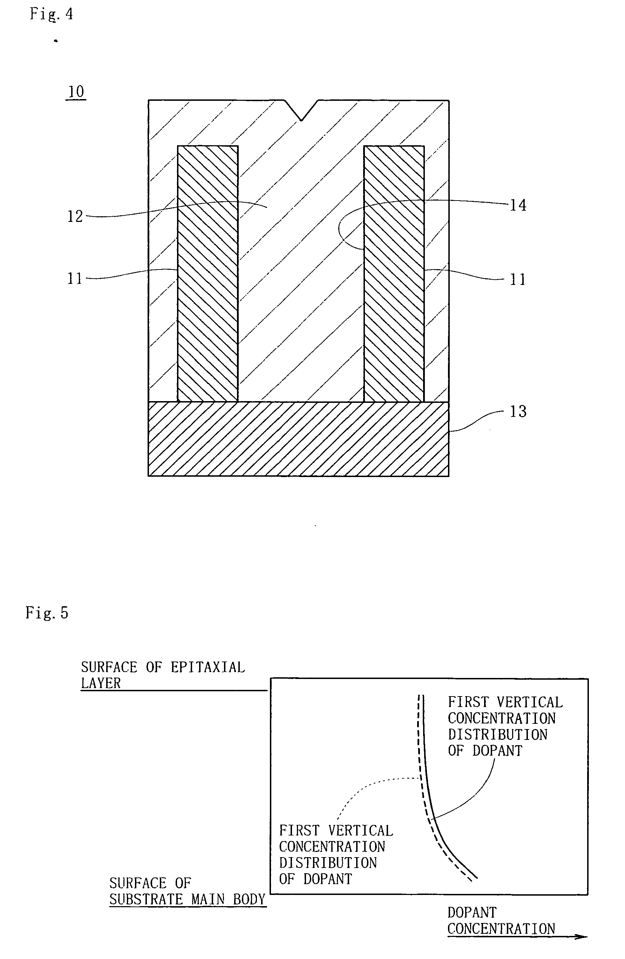

According to the invention defined in claim 2, as shown in FIGS. 4 and 5, there is provided an improvement in a semiconductor substrate having a structure in which a plurality of columnar first epitaxial layers 11 are respectively formed on a surface of a substrate main body 13 at predetermined intervals and a plurality of second epitaxial layers 12 are respectively formed in trenches 14 between the plurality of first epitaxial layers 11.

Its characteristic structure lies in that a concentration distribution of a dopant included in each first epitaxial layer 11 in a surface vertical to the surface of the substrate main body 13 is configured to match with a concentration distribution of a dopant included in each second epitaxial layer 12 in a surface vertical to the surface of the substrate main body 13.

In the semiconductor substrate defined in claim 2, since the concentration distribution of the dopant included in each first epitaxial layer 11 in a surface vertical to the surface of the substrate main body 13 has the same tendency as the concentration distribution of the dopant included in each second epitaxial layer 12 in a surface vertical to the surface of the substrate main body 13, a carrier amount contained in the first epitaxial layer 11 becomes substantially equal to a carrier amount contained in the second epitaxial layer 12 adjacent to the first epitaxial layer 11. As a result, since a carrier amount in an N-type region becomes substantially equal to a carrier amount in a P-type region adjacent to the N-type region after forming a super junction structure on a semiconductor substrate 10, a depletion layer is generated from a PN junction of the N-type region and the P-type region at the time of off, thereby completely depleting a drift region.

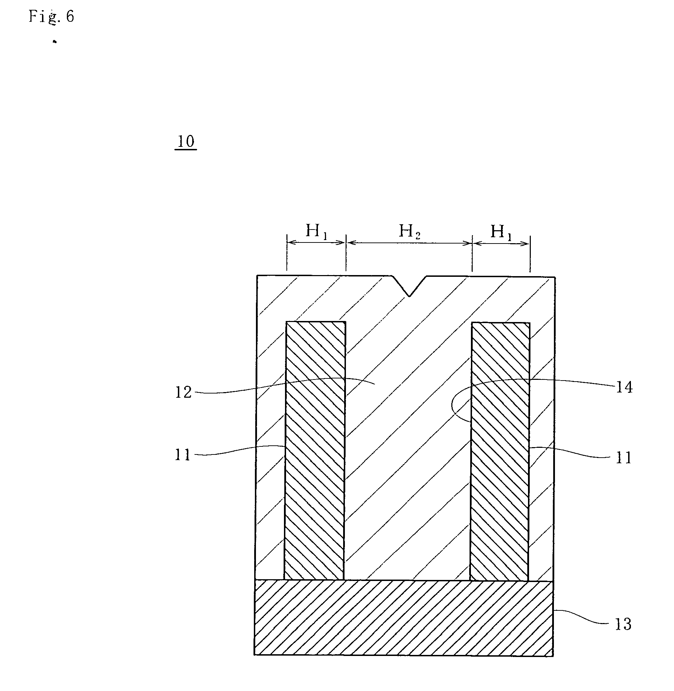

According to the invention defined in claim 3, as shown in FIG. 6, there is provided an improvement in a semiconductor substrate having a structure in which a plurality of columnar first epitaxial layers 11 are respectively formed on a surface of a substrate main body 13 at predetermined intervals and a plurality of second epitaxial layers 12 are respectively formed in trenches 14 between the plurality of first epitaxial layers 11.

Its characteristic structure lies in that one or both of a width H₁ of the first epitaxial layer 11 and a width H₂ of the second epitaxial layer 12 are set so as to satisfy a relationship of C₁ X H₁ = C₂ X H₂, where H₁ (µm) is a width of the first epitaxial layer 11, H₂ (µm) is a width of the second epitaxial layer 12, C₁ (/cm³) is a carrier concentration of the first epitaxial layer 11, and C₂ (/cm³) is a carrier concentration of the second epitaxial layer 12.

In this semiconductor substrate defined in claim 3, since one or both of the width H₁ of the first epitaxial layer 11 and the width H₂ of the second epitaxial layer 12 are set so as to satisfy the relationship of C₁ X H₁ = C₂ X H₂, a carrier amount contained in the first epitaxial layer 11 becomes substantially equal to a carrier amount contained in the second epitaxial layer 12 adjacent to the first epitaxial layer 11. As a result, a carrier amount in an N-type region becomes substantially equal to a carrier amount in a P-type region adjacent to the N-type region after forming a super junction structure on a semiconductor substrate 10, and hence a depletion layer is generated from a PN junction of the N-type region and the P-type region at the time of off, thereby completely depleting a drift region.

According to the invention defined in claim 7, as shown in FIGS. 1 to 3, there is provided an improvement in a manufacturing method of a semiconductor substrate comprising: a step of growing a first epitaxial layer 11 on a surface of a substrate main body 13; a step of forming a trench 14 in this first epitaxial layer 11; and a step of growing a second epitaxial layer 12 on a surface of the first epitaxial layer 11 and in the trench 14.

Its characteristic structure lines in further comprising: a step of measuring a concentration distribution of a dopant included in the second epitaxial layer 12 in a surface parallel with the surface of the substrate main body 13 in advance by a experiment; and a step of matching a concentration distribution of a dopant included in the first epitaxial layer 11 in a surface parallel with the surface of the substrate main body 13 with the concentration distribution of the dopant included in the second epitaxial layer 12 parallel with the surface of the substrate main body 13 when growing the first epitaxial layer 11.

In this manufacturing method of a semiconductor substrate defined in claim 7, since the concentration distribution of the dopant included in the first epitaxial layer 11 in a surface parallel with the surface of the substrate main body 13 has the same tendency as the concentration distribution of the dopant included in the second epitaxial layer 12 in a surface parallel with the surface of the substrate main body 13, it is possible to obtain the semiconductor substrate 10 defined in claim 1, i.e., the semiconductor substrate 10 which can suppress deterioration in charge balance and maintain excellent withstand voltage characteristics.

According to the invention defined in claim 8, as shown in FIGS. 4 and 5, there is provided an improvement in a manufacturing method of a semiconductor substrate comprising: a step of growing a first epitaxial layer 11 on a surface of a substrate main body 13; a step of forming a trench 14 in this first epitaxial layer 11; and a step of growing a second epitaxial layer 12 on a surface of the first epitaxial layer 11 and in the trench 14.

Its characteristic structure lies in further comprising: a step of measuring a concentration distribution of a dopant included in the second epitaxial layer 12 in a surface vertical to the surface of the substrate main body 13 in advance by an experiment; and a step of matching a concentration distribution of a dopant included in the first epitaxial layer 11 in a surface vertical to the surface of the substrate main body 13 with the concentration distribution of the dopant included in the second epitaxial layer 12 in a surface vertical to the surface of the substrate main body 13 when growing the first epitaxial layer 11.

In this manufacturing method of a semiconductor substrate defined in claim 8, since the concentration distribution of the dopant included in the first epitaxial layer 11 in a surface vertical to the surface of the substrate main body 13 has the same tendency as the concentration distribution of the dopant included in the second epitaxial layer 12 in a surface vertical to the surface of the substrate main body 13, it is possible to obtain the semiconductor substrate 10 defined in claim 2, i.e., the semiconductor substrate 10 which can suppress deterioration in charge balance and maintain excellent withstand voltage characteristics.

According to the invention defined in claim 9, as shown in FIG. 6, there is provided an improvement in a manufacturing method of a semiconductor substrate comprising: a step of growing a first epitaxial layer 11 on a surface of a substrate main body 13; a step of forming a trench 14 in this first epitaxial layer 11 to thereby make the first epitaxial layer 11 into a plurality of columnar shapes; and a step of growing a second epitaxial layer 12 on a surface of the first epitaxial layer 11 and in the trench 14.

Its characteristic structure lies in further comprising: a step of measuring a concentration distribution of a dopant included in the first epitaxial layer 11 in a surface parallel with the surface of the substrate main body 13 in advance by an experiment; and a step of measuring a concentration distribution of a dopant included in the second epitaxial layer 12 in a surface parallel with the surface of the substrate main body 13 in advance by an experiment, and in that one or both of a width H₁ of the columnar first epitaxial layer 11 and a width H₂ of the second epitaxial layer 12 are set so as to satisfy a relationship of C₁ X H₁ = C₂ X H₂, where H₁ (µm) is a width of the columnar first epitaxial layer 11, H₂ (µm) is a width of the second epitaxial layer 12, C₁ (/cm³) is a carrier concentration of the first epitaxial layer 11, and C₂ (/cm³) is a carrier concentration of the second epitaxial layer 12.

In the manufacturing method of a semiconductor substrate defined in claim 9, since one or both of the width H₁ of the first epitaxial layer 11 and the width H₂ of the second epitaxial layer 12 are set so as to satisfy the relationship of C₁ X H₁ = C₂ X H₂, it is possible to obtain the semiconductor substrate 10 defined in claim 3, i.e., the semiconductor substrate 10 which can suppress deterioration in charge balance and maintain excellent withstand voltage characteristics.

According to the invention defined in claim 13, as shown in FIG. 4, there is provided the invention set forth in one of claims 7 to 12 characterized in that a raw material gas used to form a film of the second epitaxial layer 12 is a mixed gas in which a halide is mixed in a semiconductor source gas.

In this manufacturing method of a semiconductor substrate defined in claim 13, since a supply amount of the mixed gas can be further precisely controlled by using the mixed gas in which a halide is mixed in the semiconductor source gas as the raw material gas used to form a film of the second epitaxial layer 12, voids in the second epitaxial layer 12 can be reduced, and dopant concentration distributions in the second epitaxial layer 12 in a surface parallel to or vertical to the substrate main body 13 can be matched.

As described above, according to the present invention, the plurality of columnar first epitaxial layers are respectively formed on the surface of the substrate main body at predetermined intervals, the plurality of second epitaxial layers are respectively formed in the trenches between the plurality of first epitaxial layers, and the concentration distribution of the dopant included in the first epitaxial layer in a surface parallel with the surface of the substrate main body is matched with the concentration distribution of the dopant included in the second epitaxial layer in a surface parallel with the surface of the substrate main body. Therefore, a carrier amount contained in the first epitaxial layer becomes substantially equal to a carrier amount contained in the second epitaxial layer adjacent to the first epitaxial layer. As a result, since the N-type region and the P-type region adjacent to each other have substantially the same carrier amount after forming the super junction structure on the semiconductor substrate, and hence a depletion layer is generated from the PN junction of the N-type region and the P-type region at the time of off, thereby completely depleting the drift region. Therefore, deterioration in the charge balance can be suppressed, whereby the excellent withstand voltage characteristics can be maintained.

Moreover, even if the concentration distribution of the dopant included in the first epitaxial layer in a surface vertical to the surface of the substrate main body is matched with the concentration distribution of the dopant included in the second epitaxial layer in a surface vertical to the surface of the substrate main body, or even if the width of the first epitaxial layer is set in such a manner that the widths of the first and second epitaxial layers and the carrier concentrations of the first and second epitaxial layers satisfy a predetermined relationship, the same effects can be obtained as described above.

Additionally, the concentration distribution of the dopant included in the second epitaxial layer in a surface parallel with the surface of the substrate main body is measured in advance by an experiment, and the concentration distribution of the dopant included in the first epitaxial layer in a surface parallel with the surface of the substrate main body is matched with the concentration distribution of the dopant included in the second epitaxial layer in a surface parallel with the surface of the substrate main body when growing the first epitaxial layer. As a result, there can be obtained a semiconductor substrate which can suppress deterioration in charge balance and maintain excellent withstand voltage characteristics.

Further, the concentration distribution of the dopant included in the second epitaxial layer in a surface vertical to the surface of the substrate main body is measured in advance by an experiment, and the concentration distribution of the dopant included in the first epitaxial layer in a surface vertical to the surface of the substrate main body is matched with the concentration distribution of the dopant included in the second epitaxial layer in a surface vertical to the surface of the substrate main body when growing the first epitaxial layer. Alternatively, the concentration distribution of the dopant included in each of the first and second epitaxial layers in a surface parallel with the surface of the substrate main body is measured in advance by an experiment, and one or both of the width of the columnar first epitaxial layer and the width of the second epitaxial layer are set in such a manner that the widths of the first and second epitaxial layers and the carrier concentrations of the first and second epitaxial layers satisfy a predetermined relationship. In such a case, deterioration in charge balance can be likewise suppressed, thereby obtaining a semiconductor substrate which can maintain excellent withstand voltage characteristics.

Furthermore, when the mixed gas in which a halide is mixed in the semiconductor source gas is used as the raw material gas used to form a film of the second epitaxial layer, a supply amount of this mixed gas can be further precisely controlled. Therefore, voids in the second epitaxial layer can be reduced, and the dopant concentration distributions in the second epitaxial layer in a surface parallel to or vertical to the substrate main body can be matched.

### BRIEF DESCRIPTION OF THE DRAWINGS

FIG. 1 is a cross-sectional block diagram showing a semiconductor substrate according to a first embodiment of the present invention;
FIG. 2 is a view showing dopant concentration distributions of first and second epitaxial layers in a surface parallel with a surface of a substrate main body;
FIG. 3 is a process drawing showing a manufacturing method of the semiconductor substrate;
FIG. 4 is a cross-sectional block diagram showing a semiconductor substrate according to a second embodiment of the present invention;
FIG. 5 is a view showing dopant concentration distributions of first and second epitaxial layers in a surface vertical to a surface of a substrate main body; and
FIG. 6 is a cross-sectional block diagram of a semiconductor substrate according to a third embodiment of the present invention.

### DETAILED DESCRIPTION OF THE PREFERRED EMBODIMENTS

The best mode for carrying out the present invention will now be described with reference to the accompanying drawings.

### <First Embodiment>

As shown in FIG. 1, a plurality of columnar first epitaxial layers 11 are respectively formed on a surface of a substrate main body 13 at predetermined intervals, and a plurality of second epitaxial layers 12 are respectively formed in trenches 14 between the plurality of first epitaxial layers 11. The substrate main body 13 is an N⁺-type silicon single-crystal substrate in which an impurity such as phosphor, arsenic or stibium is doped, the first epitaxial layer 11 is an N-type silicon single-crystal layer in which an impurity such as phosphor, arsenic or stibium is doped, and the second epitaxial layer 12 is a P-type silicon single-crystal layer in which an impurity such as boron, gallium or indium is doped. As shown in FIG. 2 in detail, a characteristic structure of this embodiment lies in that a concentration distribution of a dopant included in the first epitaxial layer 11 in a surface parallel with the surface of the substrate main body 13 (which will be referred to as a first parallel concentration distribution of the dopant hereinafter) is matched with a concentration distribution of a dopant included in the second epitaxial layer 12 in a surface parallel with the surface of the substrate main body 13 (which will be referred to as a second parallel concentration distribution of the dopant hereinafter). The first parallel concentration distribution of the dopant is configured to fall within a range of ±10%, or preferably, ±5% with respect to the second parallel concentration distribution of the dopant. Here, the first parallel concentration distribution of the dopant is allowed to fall within a range of ±10% with respect to the second parallel concentration distribution of the dopant because precisely matching the first parallel concentration distribution of the dopant with the second parallel concentration distribution of the dopant is very difficult. Furthermore, if the first parallel concentration distribution of the dopant falls within a range of ±10%, deterioration in charge balance can be suppressed and excellent withstand voltage characteristics can be maintained after forming a super junction structure on a substrate main body 10.

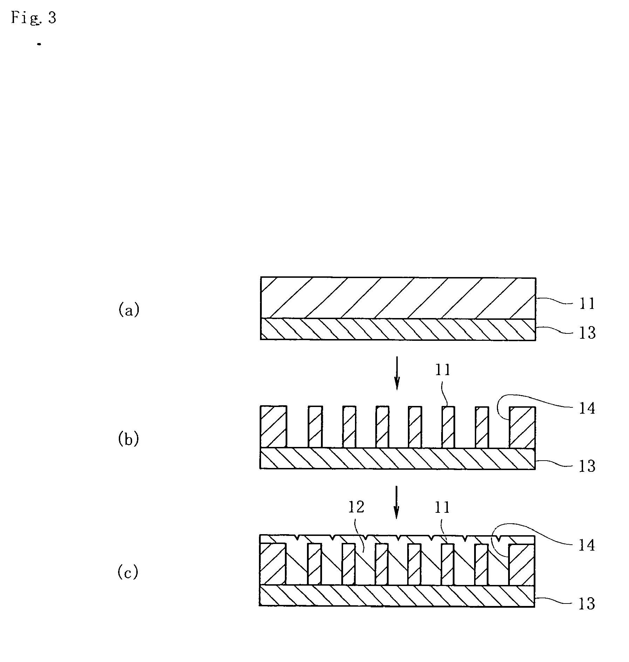

A manufacturing method of the thus configured semiconductor substrate 10 will now be described with reference to FIG. 3.

The semiconductor substrate 10 is experimentally manufactured. Specifically, first, the first epitaxial layer 11 is grown on the surface of the substrate main body 13 in a temperature range of 400 to 1200°C by a vapor growth method while supplying a silane gas as a raw material gas. Each trench 14 is formed in this first epitaxial layer 11 by a photo-etching method, and then a temperature is gradually reduced in a temperature range of 400 to 1150°C to grow the second epitaxial layer 12 on the surface of the first epitaxial layer 11 and in each trench 14 by the vapor growth method while supplying the silane gas as a raw material gas. As a result, the surface of the first epitaxial layer 11 is covered with the second epitaxial layer 12 and each trench 14 is filled with the second epitaxial layer 12. Here, the entire temperature range when growing the second epitaxial layer 12 by the vapor growth method is restricted to the range of 400 to 1150°C because there is a problem such as multicrystallization or an increase in defects if the temperature range is less than 400°C. Moreover, if the temperature range exceeds 1150°C, there is a problem that deterioration in profile occurs due to auto-doping. Additionally, the temperature is gradually reduced within the temperature range of 400 to 1150°C to grow the second epitaxial layer 12 by the vapor growth method because gradually decreasing an amount of the impurity diffused in the second epitaxial layer 12 in each trench 14 from the substrate main body 13 and the first epitaxial layer 11 stepwise changes a resistance of the second epitaxial layer 12 in each trench 14 and suppresses an influence of auto-doping from the substrate main body 13 and the first epitaxial layer 11, thereby improving embedding characteristics of each trench 14. As the vapor growth method, there is a chemical vapor growth method (a CVD method), a physical vapor growth method (a PVD method) or the like. Then, a concentration distribution of the dopant included in the second epitaxial layer 12 in a surface parallel with the surface of the substrate main body 13, i.e., the second parallel concentration distribution of the dopant is measured. Since the second parallel concentration of the dopant is equal to a concentration distribution of a carrier included in the second epitaxial layer 12 in a surface parallel with the surface of the substrate main body 13 (which will be referred to as a second parallel concentration distribution of the carrier hereinafter), this second parallel concentration distribution of the carrier is measured by a CV measurement method. Here, the CV measurement method is a method by which how an electrostatic capacity C of a semiconductor device formed of a semiconductor/an insulator/a metal varies depending on a bias voltage V is measured to evaluate electrical characteristics of the semiconductor or the like. Growth of this second epitaxial layer 12 and evaluation of the second parallel concentration distribution of the carrier may be carried out by using a PW (polished wafer) on which the first epitaxial layer 11 and the trenches 14 do not exist.

Then, the semiconductor substrate 10 as a product is manufactured. Specifically, first, the first epitaxial layer 11 is grown on the surface of the substrate main body 13 by the vapor growth method while supplying a silane gas as a raw material gas. At the time of growth of the first epitaxial layer 11 by the vapor growth method, outputs of a plurality of halogen lamps which increase a temperature in a furnace are respectively controlled in such a manner that the first parallel concentration distribution of the dopant is matched with the second parallel concentration distribution of the dopant. Alternatively, the first parallel concentration distribution of the dopant may be matched with the second parallel concentration distribution of the dopant by controlling a dopant flow quantity distribution at the time of growth of the first epitaxial layer 11. Here, it is very difficult to precisely match the first parallel concentration distribution of the dopant with the second parallel concentration distribution of the dopant. Further, if the first parallel concentration distribution of the dopant is set so as to fall within a range of ±10%, deterioration in charge balance can be suppressed and excellent withstand voltage characteristics can be maintained after forming a super junction structure on the semiconductor substrate 10. Therefore, the first parallel concentration distribution of the dopant is set so as to fall within a range of ±10%, or preferably, ±5% with respect to the second parallel concentration distribution of the dopant. After each trench 14 is formed in this first epitaxial layer 11 by the photo-etching method, a temperature is gradually reduced within a temperature range of 400 to 1150°C to grow the second epitaxial layer 12 on the surface of the first epitaxial layer 11 and in each trench 14 by the vapor growth method while supplying the silane gas as the raw material gas. It is to be noted that a mixed gas in which a halide such as hydrogen chloride, chlorine, fluorine, chlorine trifluoride, hydrogen fluoride or hydrogen bromide is mixed in an Si source gas (a semiconductor source gas) may be used in place of the silane gas. As a result, the surface of the first epitaxial layer 11 is covered with the second epitaxial layer 12, and the second epitaxial layer 12 is filled in each trench 14.

In the thus manufactured semiconductor substrate 10, since the first parallel concentration distribution of the dopant has the same tendency as the second parallel concentration distribution of the dopant, a carrier amount contained in the first epitaxial layer 11 becomes substantially equal to a carrier amount contained in the second epitaxial layer 12 adjacent to the first epitaxial layer 11. As a result, since an N-type region and a P-type region adjacent to each other have substantially the same carrier amount after forming the super junction structure on the semiconductor substrate 10, a depletion layer is generated from a PN junction of the N-type region and the P-type region at the time of off, thereby completely depleting a drift region. Therefore, deterioration in charge balance can be suppressed, thereby maintaining excellent withstand voltage characteristics.

### <Second Embodiment>

FIGS. 4 and 5 show a second embodiment of the present invention. In FIG. 4, like reference numerals denote the same components as those in FIG. 1.

In this embodiment, a concentration distribution of a dopant included in a first epitaxial layer 11 in a surface vertical to a surface of a substrate main body 13 (which will be referred to as a first vertical concentration distribution hereinafter) is configured to match with a concentration distribution of a dopant included in a second epitaxial layer 12 in a surface vertical to the surface of the substrate main body 13 (which will be referred to as a second vertical concentration distribution hereinafter) (FIGS. 4 and 5). The first vertical concentration distribution of the dopant is configured to fall within a range of ±10%, or preferably, ±5% with respect to the second vertical concentration distribution of the dopant. Here, the first vertical concentration distribution of the dopant is allowed to fall within a range of ±10% with respect to the second vertical concentration distribution of the dopant because precisely matching the first vertical concentration distribution of the dopant with the second vertical concentration distribution of the dopant is very difficult. Further, if the first vertical concentration distribution of the dopant falls within a range of ±10%, deterioration in charge balance can be suppressed and excellent withstand voltage characteristics can be maintained after forming a super junction structure on a semiconductor substrate 10.

A manufacturing method of the thus configured semiconductor substrate 10 will now be described.

The semiconductor substrate 10 is experimentally manufactured. Specifically, first, the first epitaxial layer 11 is grown on the surface of the substrate main body 13 within a temperature range of 400 to 1200°C by a vapor growth method while supplying an Si source gas (a semiconductor source gas) as a raw material gas. After each trench 14 is formed in this first epitaxial layer 11 by a photo-etching method, a temperature is gradually reduced within a temperature range of 400 to 1150°C to grow the second epitaxial layer 12 on the surface of the first epitaxial layer 11 in each trench 14 by the vapor growth method while supplying the silane gas as the raw material gas. It is to be noted that a mixed gas in which a halide such as hydrogen chloride, chlorine, fluorine, chlorine trifluoride, hydrogen fluoride or hydrogen bromide is mixed in an Si source gas (a semiconductor source gas) may be used in place of the silane gas. As a result, the surface of the first epitaxial layer 11 is covered with the second epitaxial layer 12, and the second epitaxial layer 12 is filled in each trench 14. Then, a concentration distribution of the dopant included in the second epitaxial layer 12 in a surface vertical to the surface of the substrate main body 13, i.e., the second vertical concentration distribution of the dopant is measured. Since the second vertical concentration distribution of the dopant is equal to a concentration distribution of a carrier included in the second epitaxial layer in a surface vertical to the surface of the substrate main body 13 (which will be referred to as a second vertical concentration distribution of the carrier hereinafter), this second vertical concentration distribution of the carrier is measured by an SR measurement method. Growth of this second epitaxial layer 12 and evaluation of the second vertical concentration distribution of the carrier may be carried out by using a PW (polished wafer) on which the first epitaxial layer 11 and each trench 14 do not exist.

Then, the semiconductor substrate 10 as a product is manufactured. Specifically, first, the first epitaxial layer 11 is grown on the surface of the substrate main body 13 by the vapor growth method while supplying the silane gas as the raw material gas. At this time, outputs of a plurality of halogen lamps which increase a temperature in a furnace at the time of growth of the first epitaxial layer 11 are respectively controlled in such a manner that the first vertical concentration distribution of the dopant is matched with the second vertical concentration distribution of the dopant. Alternatively, the first vertical concentration distribution of the dopant may be matched with the second vertical concentration distribution of the dopant by controlling a dopant flow quantity distribution at the time of growth of the first epitaxial layer 11. Here, precisely matching the first vertical concentration distribution of the dopant with the second vertical concentration distribution of the dopant is very difficult. Furthermore, if the first vertical concentration distribution of the dopant falls within a range of ±10%, deterioration in charge balance can be suppressed and excellent withstand voltage characteristics can be maintained after forming the super junction structure on the semiconductor substrate 10. Therefore, the first vertical concentration distribution of the dopant is set so as to fall within a range of ±10%, or preferably, ±5% with respect to the second vertical concentration distribution of the dopant. After forming each trench in this first epitaxial layer 11 by the photo-etching method, a temperature is gradually reduced within a temperature range of 400 to 1150°C to grow the second epitaxial layer 12 on the surface of the first epitaxial layer 11 and in each trench 14 by the vapor growth method while supplying the silane gas as the raw material gas. It is to be noted that a mixed gas in which a halide such as hydrogen chloride, chlorine, fluorine, chlorine trifluoride, hydrogen fluoride or hydrogen bromide is mixed in an Si source gas (a semiconductor source gas) may be used in place of the silane gas. As a result, the surface of the first epitaxial layer 11 is covered with the second epitaxial layer 12, and the second epitaxial layer 12 is filled in each trench 14.

In the thus manufactured semiconductor substrate 10, since the mixed gas containing the semiconductor source gas and the halide is used as the raw material gas in order to form a film of the second epitaxial layer 12, a supply amount of the mixed gas can be further precisely controlled as compared with the first embodiment, and voids in the second epitaxial layer 12 can be further reduced as compared with the first embodiment. Moreover, since the first vertical concentration distribution of the dopant has the same tendency as the second vertical concentration distribution of the dopant, the carrier amount contained in the first epitaxial layer 11 becomes substantially the same as the carrier amount contained in the second epitaxial layer 12 adjacent to the first epitaxial layer 11. As a result, since an N-type region and a P-type region adjacent to each other have substantially the same carrier amount after forming the super junction structure on the semiconductor substrate 10, a depletion layer is generated from a PN junction of the N-type region and the P-type region at the time of off, thereby completely depleting a drift region. Therefore, deterioration in charge balance can be suppressed, thereby maintaining excellent withstand voltage characteristics.

### <Third Embodiment>

FIG. 6 shows a third embodiment according to the present invention. In FIG. 6, like reference numerals denote the same components as those in FIG. 1.

In this embodiment, assuming that a width of a first epitaxial layer 11 is H₁ (µm), a width of a second epitaxial layer 12 is H₂ (µm), a carrier concentration of the first epitaxial layer 11 is C₁ (/cm³) and a carrier concentration of the second epitaxial layer 12 is C₂ (/cm³), one or both of the width H₁ of the first epitaxial layer 11 and the width H₂ of the second epitaxial layer 12 are set so as to satisfy a relationship of C₁ X H₁ = C₂ X H₂. One or both of the width H₁ of the first epitaxial layer 11 and the width H₂ of the second epitaxial layer 12 are set in such a manner that (C₁ X H₁) falls within a range of ±10% with respect to (C₂ X H₂) because precisely matching an amount of a dopant included in the first epitaxial layer 11 with an amount of a dopant included in the second epitaxial layer 12 adjacent to the first epitaxial layer 11 is very difficult. Additionally, if (C₁ X H₁) falls within a range of ±10%, deterioration in charge balance can be suppressed and excellent withstand voltage characteristics can be maintained after forming a super junction structure on a semiconductor substrate 10.

A manufacturing method of the thus configured semiconductor substrate 10 will now be described.

The semiconductor substrate 10 is experimentally manufactured. Specifically, first, the first epitaxial layer 11 is grown on the surface of the substrate main body 13 within a temperature range of 400 to 1200°C by a vapor growth method while supplying a silane gas as a raw material gas. At this time, a concentration distribution of the dopant included in the first epitaxial layer 11 in a surface parallel with the surface of the substrate main body 13, i.e., the first parallel concentration distribution of the dopant is measured.
Since the first parallel concentration distribution of the dopant is equal to a concentration distribution of a carrier contained in the first epitaxial layer 11 in a surface parallel with the surface of the substrate main body 13 (which will be referred to as a first parallel concentration distribution of the carrier hereinafter), this first parallel concentration distribution of the carrier is measured by a CV measurement method. Then, each trench is formed in this first epitaxial layer 11 by a photo-etching method, and then a temperature is gradually reduced within a temperature range of 400 to 1150°C to grow the second epitaxial layer 12 on the surface of the first epitaxial layer 11 and in each trench 14 by the vapor growth method while supplying the silane gas as the raw material gas. As a result, the surface of the first epitaxial layer 11 is covered with the second epitaxial layer 12, and the second epitaxial layer 12 is filled in each trench 14. Further, a concentration distribution of the dopant included in the second epitaxial layer 12 in a surface parallel with the surface of the substrate main body 13, i.e., the second parallel concentration distribution of the dopant is measured. Since the second parallel concentration distribution of the dopant is equal to a concentration distribution of a carrier contained in the second epitaxial layer 12 in a surface parallel with the surface of the substrate main body 13 (which will be referred to as a second parallel concentration distribution of the carrier hereinafter), this second parallel concentration distribution of the carrier is measured by the CV measurement method. Growth of this second epitaxial layer 12 and evaluation of the second parallel concentration distribution of the carrier may be carried out by using a PW (polished wafer) on which the first epitaxial layer 11 and each trench 14 do not exist.

Then, the semiconductor substrate 10 as a product is manufactured. Specifically, first, the first epitaxial layer 11 is grown on the surface of the substrate main body 13 under the same temperature conditions as those in the experiment, i.e., within the temperature range of 400 to 1200°C by the vapor growth method while supplying the silane gas as the raw material gas. Then, each trench 14 is formed in this first epitaxial layer 11 by the photo-etching method. At this time, a width C₁ of the first epitaxial layer 11 is set so as to satisfy a relationship of C₁ X H₁ = C₂ X H₂. That is, each trench 14 is formed in such a manner that the width C₁ of the first epitaxial layer 11 has a set value. Here, it is very difficult to precisely match an amount of the dopant contained in the first epitaxial layer 11 with an amount of the dopant contained in the second epitaxial layer 12 adjacent to the first epitaxial layer 11. Furthermore, if (C₁ X H₁) falls within a range of ±10%, deterioration of charge balance can be suppressed and excellent withstand voltage characteristics can be maintained after forming a super junction structure on the semiconductor substrate 10. Therefore, (C₁ X H₁) is set so as to fall within a range of ±10% with respect to (C₂ X H₂). Moreover, a temperature is gradually reduced within a temperature range of 400 to 1150°C to grow the second epitaxial layer 12 on the surface of the first epitaxial layer 11 and in each trench 14 by the vapor growth method while supplying the silane gas as the raw material gas. As a result, the surface of the first epitaxial layer 11 is covered with the second epitaxial layer 12, and the second epitaxial layer 12 is filled in each trench 14.

In the thus manufactured semiconductor substrate 10, since one or both of the width H₁ of the first epitaxial layer 11 and the width H₂ of the second epitaxial layer 12 are set so as to satisfy the relationship of C₁ X H₁ = C₂ X H₂, an amount of the carrier contained in the first epitaxial layer 11 becomes substantially equal to an amount of the carrier contained in the second epitaxial layer 12 adjacent to the first epitaxial layer 11. As a result, since an N-type region and a P-type region adjacent to each other have substantially the same carrier amount after forming the super junction structure on the semiconductor substrate 10, a depletion layer is generated from a PN junction of the N-type region and the P-type region at the time of off, thereby completely depleting a drift region. Therefore, deterioration in the charge balance can be suppressed, thus maintaining excellent withstand voltage characteristics.

It is to be noted that the substrate main body and the first and the second epitaxial layers are formed of a silicon single crystal in the first to third embodiments, but they may be formed of a GaAs single crystal, an InP single crystal, a ZnS single crystal, a ZnSe single crystal or the like. In case of the GaAs single crystal, it is possible to use a mixed gas in which a halide such as hydrogen chloride, chlorine, fluorine, chlorine trifluoride, hydrogen fluoride, hydrogen bromide or the like is mixed in a semiconductor source gas such as trimethyl gallium, triethyl gallium, trimethyl arsenic, triethyl arsenic, arsine or the like as the raw material gas used to form the epitaxial layers. Additionally, in case of the InP single crystal, it is possible to use a mixed gas in which a halide such as hydrogen chloride, chlorine, fluorine, chlorine trifluoride, hydrogen fluoride, hydrogen bromide or the like is mixed in a semiconductor source gas such as trimethyl indium, triethyl indium, indium chloride, trimethyl phosphor, triethyl phosphor, phosphine or the like as the raw material gas used to form the epitaxial layers. Further, in case of the ZnS single crystal, it is possible to use a mixed gas in which a halide such as hydrogen chloride, chlorine, fluorine, chlorine trifluoride, hydrogen fluoride, hydrogen bromide or the like is mixed in a semiconductor source gas such as trimethyl zinc, triethyl zinc, hydrogen sulfide or the like as the raw material gas used to form the epitaxial layers. Furthermore, in case of the ZnSe single crystal, it is possible to use a mixed gas in which a halide such as hydrogen chloride, chlorine, fluorine, chlorine trifluoride, hydrogen fluoride, hydrogen bromide or the like is mixed in a semiconductor source gas such as trimethyl zinc, triethyl zinc, hydrogen selenide or the like as the raw material gas used form the epitaxial layers.

## Claims

1. A semiconductor substrate comprising: a plurality of columnar first epitaxial layers (11) respectively formed on a surface of a substrate main body (13) at predetermined intervals; and a plurality of second epitaxial layers (12) respectively formed in trenches (14) between the plurality of first epitaxial layers (11),
wherein a concentration distribution of a dopant included in the first epitaxial layer (11) in a surface parallel with the surface of the substrate main body (13) is configured to match with a concentration distribution of a dopant included in the second epitaxial layer (12) in a surface parallel with the surface of the substrate main body (13).

2. A semiconductor substrate comprising: a plurality of columnar first epitaxial layers (11) respectively formed on a surface of a substrate main body (13) at predetermined intervals; and a plurality of second epitaxial layers (12) respectively formed in trenches (14) between the plurality of first epitaxial layers (11),
wherein a concentration distribution of a dopant included in the first epitaxial layer (11) in a surface vertical to the surface of the substrate main body (13) is configured to match with a concentration distribution of a dopant included in the second epitaxial layer (12) in a surface vertical to the surface of the substrate main body (13).

3. A semiconductor substrate comprising: a plurality of columnar first epitaxial layers (11) respectively formed on a surface of a substrate main body (13) at predetermined intervals; and a plurality of second epitaxial layers (12) respectively formed in trenches (14) between the plurality of first epitaxial layers (11),
wherein one or both of a width H₁ of the first epitaxial layer (11) and a width H₂ of the second epitaxial layer (12) are set so as to satisfy a relationship of C₁ X H₁ = C₂ X H₂, where H₁ (µm) is a width of the first epitaxial layer (11), H₂ (µm) is a width of the second epitaxial layer (12), C₁ (/cm³) is a carrier concentration of the first epitaxial layer (11) and C₂ (/cm³) is a carrier concentration of the second epitaxial layer (12).

4. The semiconductor substrate according to claim 1, wherein the concentration distribution of the dopant included in the first epitaxial layer (11) in a surface parallel with the surface of the substrate main body (13) is set so as to fall within a range of ±10% with respect to the concentration distribution of the dopant included in the second epitaxial layer (12) in a surface parallel with the surface of the substrate main body (13).

5. The semiconductor substrate according to claim 2, wherein the concentration distribution of the dopant included in the first epitaxial layer (11) in a surface vertical to the surface of the substrate main body (13) is set so as to fall within a range of ±10% with respect to the concentration distribution of the dopant included in the second epitaxial layer (12) in a surface vertical to the surface of the substrate main body (13).

6. The semiconductor substrate according to claim 3, wherein one or both of the width H₁ of the first epitaxial layer (11) and the width H₂ of the second epitaxial layer (12) are set in such a manner that (C₁ X H₁) falls within a range of ±10% with respect to (C₂ X H₂).

7. A manufacturing method of a semiconductor substrate, comprising steps of: growing a first epitaxial layer (11) on a surface of a substrate main body (13); forming a trench (14) in the first epitaxial layer (11); and growing a second epitaxial layer (12) on a surface of the first epitaxial layer (11) and in the trench (14),
wherein the manufacturing method of a semiconductor substrate further comprises steps of:
measuring a concentration distribution of a dopant included in the second epitaxial layer (12) in a surface parallel with the surface of the substrate main body (13) in advance by an experiment; and
matching a concentration distribution of a dopant included in the first epitaxial layer (11) in a surface parallel with the surface of the substrate main body (13) with the concentration distribution of the dopant included in the second epitaxial layer (12) in a surface parallel with the surface of the substrate main body (13) when growing the first epitaxial layer (11).

8. A manufacturing method of a semiconductor substrate, comprising steps of: growing a first epitaxial layer (11) on a surface of a substrate main body (13); forming a trench (14) in the first epitaxial layer (11); and growing a second epitaxial layer (12) on a surface of the first epitaxial layer (11) and in the trench (14),
wherein the manufacturing method of a semiconductor substrate further comprises steps of:
measuring a concentration distribution of a dopant included in the second epitaxial layer (12) in a surface vertical to the surface of the substrate main body (13) in advance by an experiment; and
matching a concentration distribution of a dopant included in the first epitaxial layer (11) in a surface vertical to the surface of the substrate main body (13) with the concentration distribution of the dopant included in the second epitaxial layer (12) in a surface vertical to the surface of the substrate main body (13) when growing the first epitaxial layer (11).

9. A manufacturing method of a semiconductor substrate, comprising steps of: growing a first epitaxial layer (11) on a surface of a substrate main body (13); forming a trench (14) in the first epitaxial layer (11) to thereby make the first epitaxial layer (11) into a plurality of columnar shapes; and growing a second epitaxial layer (12) on a surface of the first epitaxial layer (11) and in the trench (14),
wherein the manufacturing method of a semiconductor substrate further comprises steps of:
measuring a concentration distribution of a dopant included in the first epitaxial layer (11) in a surface parallel with the surface of the substrate main body (13) in advance by an experiment; and
measuring a concentration distribution of a dopant included in the second epitaxial layer (12) in a surface parallel with the surface of the substrate main body (13)in advance by an experiment, and
one or both of a width H₁ of the first epitaxial layer (11) and a width H₂ of the second epitaxial layer (12) are set so as to satisfy a relationship of C₁ X H₁ = C₂ X H₂, where H₁ (µm) is a width of the columnar first epitaxial layer (11), H₂ (µm) is a width of the second epitaxial layer (12), C₁ (/cm³) is a carrier concentration of the first epitaxial layer (11) and C₂ (/cm³) is a carrier concentration of the second epitaxial layer (12).

10. The manufacturing method of a semiconductor substrate according to claim 7, wherein the concentration distribution of the dopant included in the first epitaxial layer (11) in a surface parallel with the surface of the substrate main body (13) falls within a range of ±10% with respect to the concentration distribution of the dopant included in the second epitaxial layer (12) in a surface parallel with the surface of the substrate main body (13).

11. The manufacturing method of a semiconductor substrate according to claim 8, wherein the concentration distribution of the dopant included in the first epitaxial layer (11) in a surface vertical to the surface of the substrate main body (13) falls within a range of ±10% with respect to the concentration distribution of the dopant included in the second epitaxial layer (12) in a surface vertical to the surface of the substrate main body (13).

12. The manufacturing method of a semiconductor substrate according to claim 9, wherein one or both of the width H₁ of the columnar first epitaxial layer (11) and the width H₂ of the second epitaxial layer (12) are set in such a manner that (C₁ X H₁) falls within a range of ±10% with respect to (C₂ X H₂).

13. The manufacturing method of a semiconductor substrate according to any one of claims 7 to 12, wherein a raw material gas which is used to form a film of the second epitaxial layer (12) is a mixed gas in which a halide is mixed in a semiconductor source gas.
